# EUROPEAN PATENT APPLICATION

(11) **EP 2 312 920 A2**
(43) Date of publication of application: **20.04.2011**
(21) Application number: 10179078.0
(22) Date of filing: 23.09.2010
(51) Int. Cl.: H05K 1/14, H05K 3/36, H01L 23/498, H05K 3/00

(54) **Interconnect board, printed circuit board unit, and method**

(30) Priority: 02.10.2009 JP 2009230912
(71) Applicant: FUJITSU LIMITED, Kawasaki-shi, Kanagawa 211-8588 (JP)
(72) Inventor: Koide, Masateru, Kawasaki-shi Kanagawa 211-8588 (JP); Mizutani, Daisuke, Kawasaki-shi Kanagawa 211-8588 (JP)
(74) Representative: Wilding, Frances Ward

(57) **Abstract**

An interconnect board for interconnecting and arranged between a first circuit board and a second circuit board, the interconnect board includes a conductive plate including a connection terminal to be electrically connected to a power supply terminal or a ground terminal of each of the first circuit board and the second circuit board, an insulating member wrapping the conductive plate except for the connection terminal, and a conductive member penetrating the insulating member to electrically connect a signal terminal of the first circuit board to a signal terminal of the second circuit board.

## Description

### FIELD

The embodiments discussed herein are related to an interconnect board, a printed circuit board unit, and a method for fabricating interconnect board.

### BACKGROUND

Semiconductor elements in semiconductor-element packages are getting thinner and larger in recent years. When the semiconductor elements are fixed on resin package substrates, a difference between a thermal expansion coefficient of the semiconductor elements and that of the package substrates causes inconvenience: the semiconductor elements hardly deflect because of heat, whereas the package substrates deflect or bend because of heat. This inconvenience may cause disconnection in electrical joint portions of the semiconductor elements and the package substrates.

Stainless or copper stiffening members (hereinafter, referred to as stiffeners) are attached on the package substrates to reduce the thermal deflection or bending of the package substrates. In this way, disconnection is avoided in the electrical joint portions of the semiconductor elements and the package substrates.

However, the foregoing related art has following disadvantages. More specifically, in the semiconductor-element packages, capacitors are generally arranged on a surface of the package substrates opposite to a surface mounting the semiconductor elements to face the semiconductor elements for better electric performance. To avoid interference between the capacitors and circuit boards for mounting the semiconductor-element packages, low-profile capacitors are used, or a hole is bored or countersunk at a portion of the circuit boards that interferes with the capacitors.

However, since the low-profile capacitors are expensive, the use of the low-profile capacitors unfortunately increases a fabrication cost of the semiconductor-element packages. Additionally, boring or countersinking a hole in the circuit boards unfortunately decreases electric performance of the semiconductor-element packages and the circuit boards.

The decrease in the electric performance indicates the following. For example, when a wire for supplying electric power to the semiconductor-element packages is arranged to detour around the bored or countersunk portion, the wire becomes longer than other wires for supplying electric power. Since voltage drops in proportion to length of a wire, it becomes difficult to maintain potentials of the wires having different lengths at a uniform level.

The followings are reference documents.

[Patent Document 1] Japanese Laid-open Patent Publication No.2000-323610

[Patent Document 2] Japanese Laid-open Patent Publication No.2004-289133

### SUMMARY

Accordingly, it is considered desirable to provide an interconnect board, a printed circuit board unit, and a method for fabricating an interconnect board to mount a semiconductor-element package on a circuit board without increasing a fabrication cost of the semiconductor-element package and without decreasing electric performance of the semiconductor-element package and the circuit board.

According to an aspect of the embodiment, an interconnect board for interconnecting and arranged between a first circuit board and a second circuit board, the interconnect board includes a conductive plate including a connection terminal to be electrically connected to a power supply terminal or a ground terminal of each of the first circuit board and the second circuit board, an insulating member wrapping the conductive plate except for the connection terminal, and a conductive member penetrating the insulating member to electrically connect a signal terminal of the first circuit board to a signal terminal of the second circuit board.

### BRIEF DESCRIPTION OF DRAWINGS

FIG. 1 is a diagram of a cross section of a board unit according to a first embodiment viewed from a lateral side thereof;

FIG. 2 is a diagram illustrating a configuration of an interposer according to a second embodiment;

FIGs. 3A-3C are diagrams illustrating processes for fabricating the interposer according to the second embodiment;

FIG. 4 is a flowchart illustrating a procedure for fabricating the interposer according to the second embodiment;

FIG. 5 is a diagram illustrating processes for mounting a large scale integration (LSI) package on the interposer according to the second embodiment;

FIG. 6 is a diagram illustrating a process for mounting an LSI package on a mother board using the interposer according to the second embodiment;

FIG. 7 is a flowchart illustrating a procedure for mounting an LSI package on a mother board using the interposer according to the second embodiment; and

FIG. 8 is a diagram illustrating a comparative example for mounting an LSI package on a mother board.

### DESCRIPTION OF EMBODIMENTS

Preferred embodiments of the present techniques will be explained with reference to accompanying drawings.

An interconnect board, a printed circuit board unit, and a method for fabricating an interconnect board according to embodiments of the disclosed technology will be described in detail below based on the accompanying drawings. The interconnect board indicates an electronic component for mounting, on a circuit board, a semiconductor-element package including a semiconductor element mounted on a package substrate. The disclosed technology is not limited by the embodiments described below.

### [First embodiment]

### [Configuration of board unit and interconnect board]

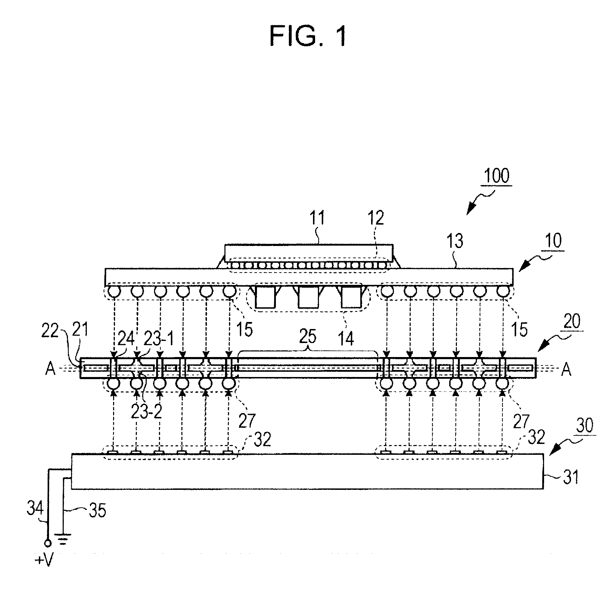

FIG. 1 is a diagram of a cross section of a board unit according to a first embodiment viewed from a lateral side thereof. More specifically, FIG. 1 is a diagram of a first circuit board 10, an interconnect board 20, and a second circuit board 30 included in a board unit 100 according to the first embodiment, each viewed from a lateral side thereof. FIG. 1 illustrates a sectional view of the interconnect board 20. As illustrated in FIG. 1, predetermined portions of the first circuit board 10, the interconnect board 20, and the second circuit board 30 are joined together in accordance with dotted-line arrows of FIG. 1, whereby the first circuit board 10 is mounted on the second circuit board 30 with the interconnect board 20.

In the first circuit board 10, a semiconductor element 11 is mounted on one surface of a package substrate 13 to be electrically connected to the package substrate 13 through connection terminals 12. For example, solder balls, lead wires, or electrode pads function as the connection terminals 12.

Electronic components 14, such as capacitors, and connection terminals 15 are arranged on the other surface of the package substrate 13 without the semiconductor element 11. The electronic components 14 are arranged to face the semiconductor element 11 across the package substrate 13.

The electronic components 14 are electrically connected to the semiconductor element 11 through predetermined electric wiring, not illustrated, in layers of the package substrate 13. The semiconductor element 11 is also connected to the connection terminals 15 through predetermined electric wiring, not illustrated, in the layers of the package substrate 13. The connection terminals 15 are arranged to surround the electronic components 14 on the other surface of the package substrate 13 without the semiconductor element 11.

The interconnect board 20 includes an insulating layer 21 and a metal plate 22 wrapped by the insulating layer 21. The insulating layer 21 is an example of the insulating member. The metal plate 22 is an example of the conductive plate. The interconnect board 20 is, for example, rectangular or square and has a predetermined thickness. The insulating layer 21 is plate-like and made of, for example, a glass fiber reinforced epoxy resin having a flame resistance of FR-4 or a non-conductive resin having strength equal to or higher than the glass fiber reinforced epoxy resin. The metal plate 22 is made of, for example, a copper foil or a metal having conductivity equal to or higher than copper. Thanks to the insulating layer 21 and the metal plate 22, the interconnect board 20 has strength enough to suppress of bending and deflection of the first circuit board 10.

The interconnect board 20 includes first connection terminals 23-1 incorporated in the metal plate 22. The first connection terminals 23-1 penetrate the insulating layer 21 from a predetermined position of the metal plate 22 to be exposed on the surface for mounting the first circuit board 10. The interconnect board 20 also includes second connection terminals 23-2 incorporated in the metal plate 22. The second connection terminals 23-2 penetrate the insulating layer 21 from a predetermined position of the metal plate 22 to be exposed on a surface facing the second circuit board 30. Furthermore, the interconnect board 20 includes metal piles 24 penetrating the insulating layer 21 and the metal plate 22 from the surface for mounting the first circuit board 10 to the surface facing the second circuit board 30. The metal piles 24 are an example of the conductive member.

The first connection terminals 23-1 are electrically connected to a power supply terminal and a ground terminal of the first circuit board 10 through the connection terminals 15. Similarly, the second connection terminals 23-2 are electrically connected to a power supply terminal and a ground terminal of the second circuit board 30 through connection terminals 27. Since the metal plate 22 is formed as one structure at a plane taken along line A-A illustrated in FIG. 1, the metal plate 22 functions as a power supply layer or a ground layer in the interconnect board 20. The metal piles 24 electrically connect signal terminals of the first circuit board 10 to corresponding signal terminals of the second circuit board 30.

As illustrated in FIG. 1, the interconnect board 20 may have more than one first connection terminal 23-1 and more than one second connection terminal 23-2. In such a case, when one of the first connection terminals 23-1 and one of the second connection terminals 23-2 are connected to the power supply terminals of the first circuit board 10 and the second circuit board 30, respectively, the metal plate 22 function as the power supply layer. Similarly, when one of the first connection terminals 23-1 and one of the second connection terminals 23-2 are connected to the ground terminals of the first circuit board 10 and the second circuit board 30, respectively, the metal plate 22 functions as the ground layer. The number of the metal piles 24 is equal to the number of the signal terminals of the first circuit board 10 and the number of the corresponding signal terminals of the second circuit board 30. In FIG. 1, the reference characters are representatively attached to one of the first connection terminals 23-1, one of the second connection terminals 23-2, and one of the metal piles 24, and the reference characters for the other first connection terminals 23-1, the other second connection terminals 23-2, and the other metal piles 24 are omitted.

The first connection terminals 23-1 and the second connection terminals 23-2 are arranged in accordance with positions of the power supply terminals and the ground terminals of the first circuit board 10 and the second circuit board 30, respectively. The metal piles 24 are arranged in accordance with positions of the signal terminals of the first circuit board 10 and the corresponding signal terminals of the second circuit board 30.

The interconnect board 20 has a through hole 25 penetrating the insulating layer 21 and the metal plate 22 at a range where the insulating layer 21 faces the electronic components 14 of the first circuit board 10. The range where the insulating layer 21 faces the electronic components 14 is in, for example, a rectangular or square shape. The through hole 25 allows physical interference between the electronic components 14 and the interconnect board 20 to be avoided when the interconnect board 20 is arranged between the first circuit board 10 and the second circuit board 30.

The second circuit board 30 includes connection terminals 32 on a surface of a substrate 31 to be connected to the interconnect board 20. The connection terminals 32 are connected to the second connection terminals 23-2 or the metal piles 24 of the interconnect board 20. The second circuit board 30 also includes a power supply line 34 for supplying an electric signal to the first circuit board 10 by using at least one of the metal piles 24 as a power supply conductive member. Additionally, the second circuit board 30 includes a ground line 35 for connecting the first circuit board 10 to ground through the first connection terminals 23-1, the metal plate 22, and the second connection terminals 23-2 of the interconnect board 20.

Each connection terminal of the interconnect board 20 is connected to the corresponding connection terminal of the first circuit board 10 or the second circuit board 30 by reflow soldering using a solder ball. However, the connection method is not limited to the reflow soldering and the connection may be made with an adhesive or by directly soldering the corresponding connection terminals.

As described above, in accordance with the first embodiment, the interconnect board 20 electrically connects the first circuit board 10 to the second circuit board 30. Additionally, the insulating layer 21 of the interconnect board 20 functions as a stiffener. Accordingly, such a configuration allows the interconnect board 20 to suppress stress of bending and deflection of the first circuit board 10.

### [Second embodiment]

In a following embodiment, a description will be given for a large scale integration (LSI) serving as a semiconductor element, an interposer serving as an interconnect board, and a mother board of an electronic device serving as a circuit board, for example. However, the disclosed technology is not limited to the LSI, the interposer, and the mother board, and may be widely applied to general semiconductor elements, general interconnect boards, and general circuit boards to achieve an object thereof.

### [Configuration of interposer]

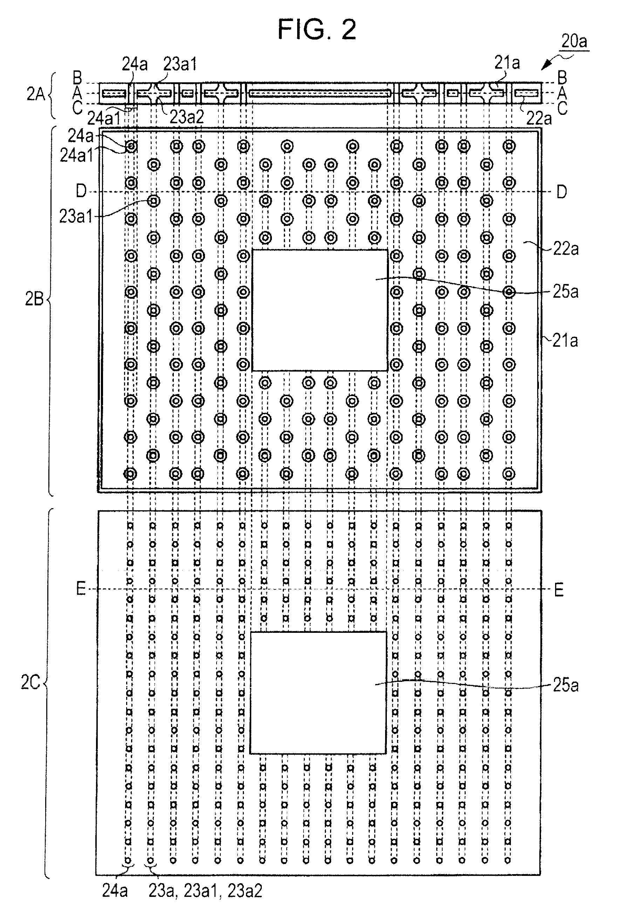

FIG. 2 is a diagram illustrating an interposer according to a second embodiment. FIG. 2 illustrates a cross section 2A of an interposer 20a according to the second embodiment. In FIG. 2, a reference character is representatively attached to one of similar components and reference characters for the other similar components are omitted.

FIG. 2 also illustrates a surface 2B of the interposer 20a taken along line A-A of the cross section 2A. Additionally, FIG. 2 illustrates a surface 2C of the interposer 20a taken along line B-B or C-C of the cross section 2A. The cross section 2A corresponds to a cross section taken along line D-D of the surface 2B or a cross section taken along line E-E of the surface 2C.

In the cross section 2A illustrated in FIG. 2, line B-B of the interposer 20a indicates a surface for mounting an LSI package, not illustrated, whereas line C-C of the interposer 20a indicates a surface facing a surface of a mother board, not illustrated, for mounting the interposer 20a.

The interposer 20a includes a plate-like insulating layer 21a, made of a glass fiber reinforced epoxy resin and serving as a substrate. Accordingly, the interposer 20a has a thermal expansion coefficient smaller than a package substrate of the LSI package. When the LSI package is mounted on the interposer 20a and corresponding connection terminals thereof are fixed together, the interposer 20a functions as a stiffener for suppressing thermal expansion of the package substrate of the LSI package caused by heat generated by an LSI of the LSI package.

The interposer 20a includes a metal plate 22a, such as a copper foil, wrapped by the insulating layer 21a. The metal plate 22a is formed as one structure in the surface taken along line A-A. As illustrated in the cross section 2A, the metal plate 22a includes a plurality of connection terminals penetrating the insulating layer 21a and exposed on the surface for mounting the LSI package (hereinafter, referred to as the LSI-package mounting surface) indicated by line B-B and the surface facing the mother board (hereinafter, referred to as mother-board facing surface) indicated by line C-C.

The connection terminals penetrating the insulating layer 21a from the metal plate 22a to be exposed on the LSI-package mounting surface indicated by line B-B are referred to as first connection terminals 23a1. Similarly, the connection terminals penetrating the insulating layer 21a from the metal plate 22a to be exposed on the mother-board facing surface indicated by line C-C are referred to as second connection terminals 23a2. The first connection terminals 23a1 and the second connection terminals 23a2 are exposed on the LSI-package mounting surface and the mother-board facing surface to form pairs with respect to the metal plate 22a. As illustrated in the cross section 2A of FIG. 2, the interposer 20a includes more than one pair of the first connection terminal 23a1 and the second connection terminal 23a2.

The first connection terminals 23a1 electrically connect, with solder balls, the metal plate 22a of the interposer 20a to a power supply terminal or a ground terminal of the LSI package mounted on the interposer 20a. The second connection terminals 23a2 electrically connect, with solder balls, the metal plate 22a of the interposer 20a to a power supply terminal or a ground terminal of the mother board for mounting the interposer 20a. Accordingly, the metal plate 22a of the interposer 20a functions as a power supply layer for supplying electric power fed from the mother board to the LSI of the LSI package or as a ground layer for connecting the LSI to ground.

Since the metal plate 22a is formed as one structure, it is possible to supply electric power to the LSI of the LSI package and connect the LSI to ground by connecting one of the second connection terminals 23a2 to the power supply terminal and the ground terminal of the mother board, respectively.

As illustrated in 2A of FIG. 2, the interposer 20a includes a plurality of metal piles 24a made of copper that penetrate the metal plate 22a and the insulating layer 21a from the LSI-package mounting surface indicated by line B-B to the mother-board facing surface indicated by line C-C.

As described above, the metal plate 22a is wholly wrapped by the insulating layer 21a. As illustrated in 2A and 2B of FIG. 2, the metal piles 24a have an inside diameter smaller than through holes 24a1 provided in the metal plate 22a to allow the corresponding metal piles 24a to penetrate therethrough. In this way, the insulating layer 21a insulates the metal piles 24a from the metal plate 22a. Accordingly, each of the metal piles 24a electrically connects a signal terminal of the LSI package to a corresponding signal terminal of the mother board independently. As illustrated in 2B of FIG. 2, ends of the metal plate 22a are also wrapped by the insulating layer 21a.

As illustrated in 2C of FIG. 2, in the interposer 20a, the metal piles 24a and the first connection terminals 23a1 or the second connection terminals 23a2 are exposed, as connection terminals, in predetermined arrangement on the LSI-package mounting surface indicated by line B-B or the mother-board facing surface indicated by line C-C.

As illustrated in 2B and 2C of FIG. 2, the interposer 20a has a through hole 25a at a range of the interposer 20a where capacitors arranged on the opposite surface of the LSI package to the surface mounting the LSI physically interfere with the interposer 20a when the LSI package is mounted on the LSI-mounting surface indicated by line B-B.

The through hole 25a in a rectangular or square shape penetrates the metal plate 22a and the insulating layer 21a of the interposer 20a. When the LSI package is mounted on the interposer 20a, the through hole 25a allows the physical interference between the interposer 20a and the capacitors arranged on the opposite surface of the LSI package to the surface mounting the LSI to be avoided.

### [Processes for fabricating interposer]

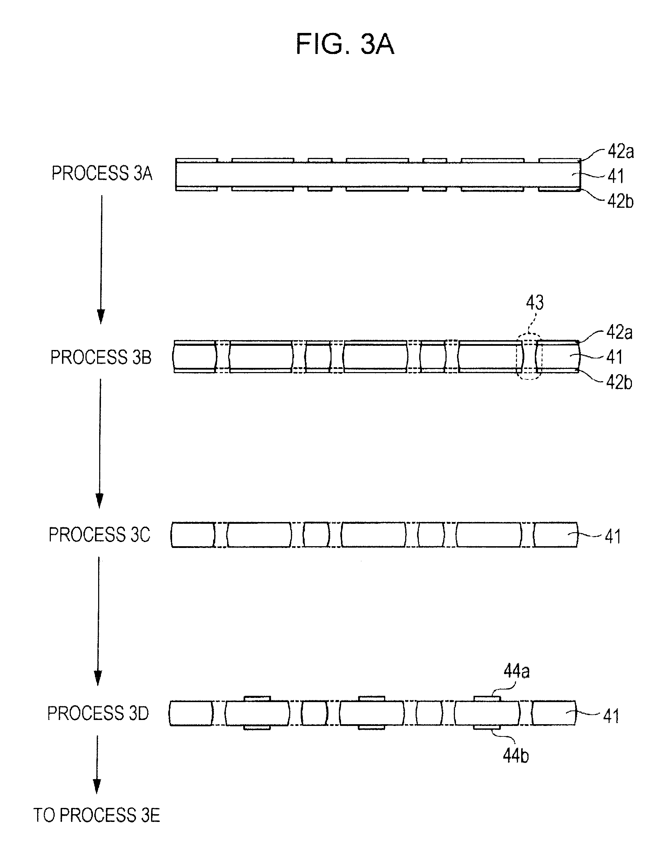

FIGs. 3A-3C are diagrams illustrating processes for fabricating the interposer according to the second embodiment. The interposer 20a is fabricated manually or by a predetermined fabrication apparatus. FIGs. 3A-3C are diagrams of a cross section of the interposer 20a in each fabrication process viewed from a lateral side thereof. In FIGs. 3A-3C, a reference character is representatively attached to one of similar components and reference characters for the other similar components are omitted.

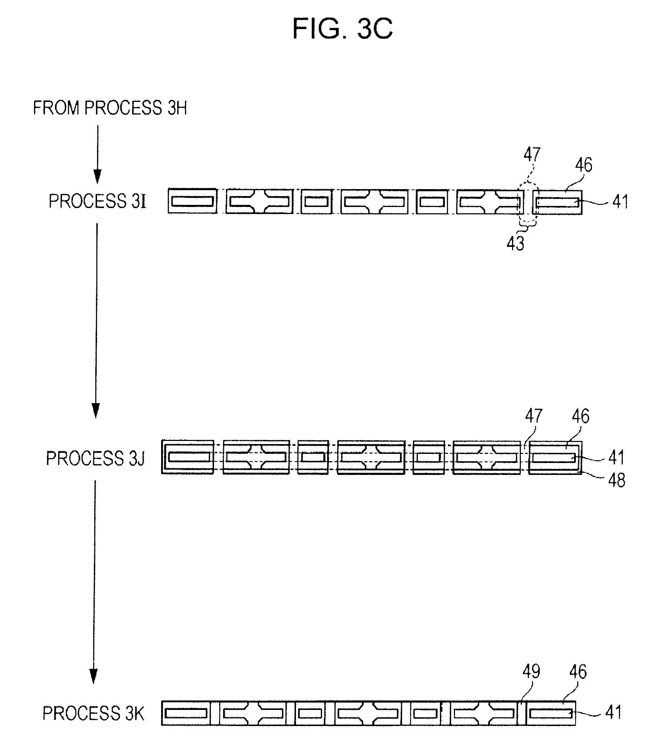

As illustrated in PROCESS 3A of FIG. 3A, resists 42a and 42b for use in formation of through holes 43 illustrated in PROCESS 3B are applied on a front surface and a back surface of a thin plate-like copper foil 41 (e.g., approximately 1-2 mm thick), respectively. The copper foil 41 is an example of a plate-like conductive member having a low thermal expansion property. The through holes 43 of the copper foil 41 are for forming metal piles (vias) 49 to be described with reference to PROCESS 3K of FIG. 3C. Each of the resists 42a and 42b is a sheet having perforated areas in a shape of the through holes 43 at positions of the through holes 43.

As illustrated in PROCESS 3B, the through holes 43 are then formed by etching at the perforated areas of the resists 42a and 42b applied on the copper foil 41. Thereafter, the resists 42a and 42b used in the formation of the through holes 43 are removed from the copper foil 41 as illustrated in PROCESS 3C.

As illustrated in PROCESS 3D, resists 44a and 44b for use in formation of terminals of a power supply layer or a ground layer are applied on the copper foil 41. The resists 44a and 44b for use in formation of the terminals of the power supply layer or ground layer are applied in a shape of the terminals at positions of the terminals.

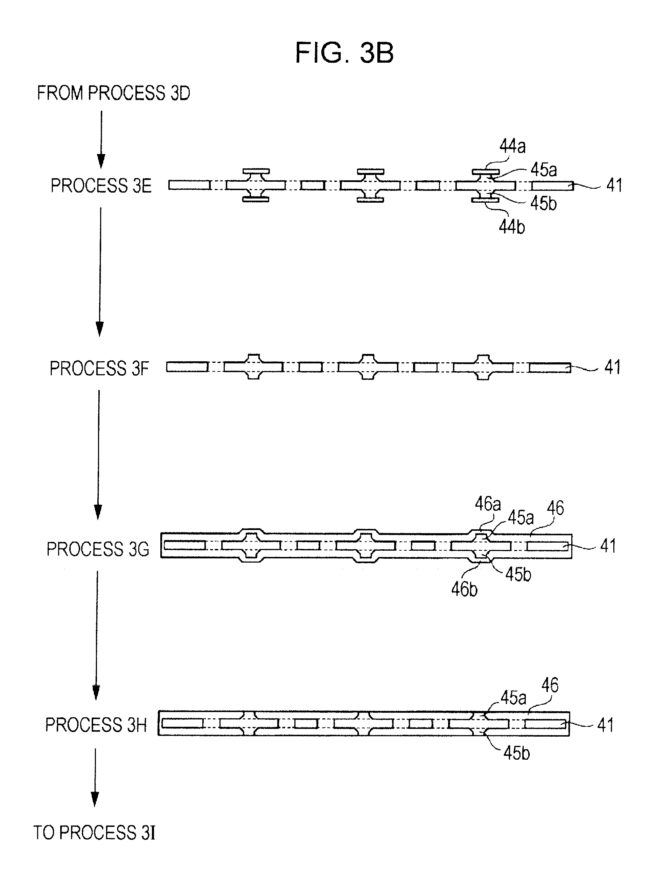

Thereafter, as illustrated in PROCESS 3E of FIG. 3B, first connection terminals 45a and the second connection terminals 45b of the power supply layer or the ground layer are formed by etching at the positions of the copper foil 41 having the applied resists 44a and 44b, respectively. The resists 44a and 44b used in the formation of the terminals of the power supply layer or ground layer are then removed from the copper foil 41 as illustrated in PROCESS 3F.

As illustrated in PROCESS 3G, an insulating layer 46 is formed to wrap the copper foil 41. Since the insulating layer 46 having a uniform thickness is formed to wrap the copper foil 41 in PROCESS 3G, the insulating layer 46 covering the first connection terminals 45a and the second connection terminals 45b has protruding parts 46a and 46b corresponding to ends of the first connection terminals 45a and the second connection terminals 45b, respectively.

Thereafter, as illustrated in PROCESS 3H, the protruding parts 46a and 46b of the insulating layer 46, i.e., parts corresponding to the ends of the first connection terminals 45a and the second connection terminals 45b illustrated in PROCESS 3G, are ground so that the ends of the first connection terminals 45a and the second connection terminals 45b are exposed, respectively. The exposed ends of the first connection terminals 45a and the second connection terminals 45b constitute the same plane as the insulating layer 46.

As illustrated in PROCESS 3I of FIG. 3C, through holes 47 are then formed, by laser processing, in the through holes 43 of the copper foil 41 wrapped by the insulating layer 46 so that the through holes 47 have an inside diameter smaller than the through holes 43. Since the inside diameter of the through holes 47 is smaller than that of the through holes 43 as illustrated in PROCESS 3I, inside of the through holes 43 is covered with the insulating layer 46.

Thereafter, as illustrated in PROCESS 3J, a resist 48 covering the insulating layer 46 is applied to form the metal piles 49 penetrating the insulating layer 46 and the copper foil 41 in the through holes 47. As illustrated in PROCESS 3K, the metal piles 49 are then formed in the through holes 47 by copper plating, The resist 48 used in the formation of the metal piles 49 is then removed from the insulating layer 46.

### [Processes for fabricating interposer]

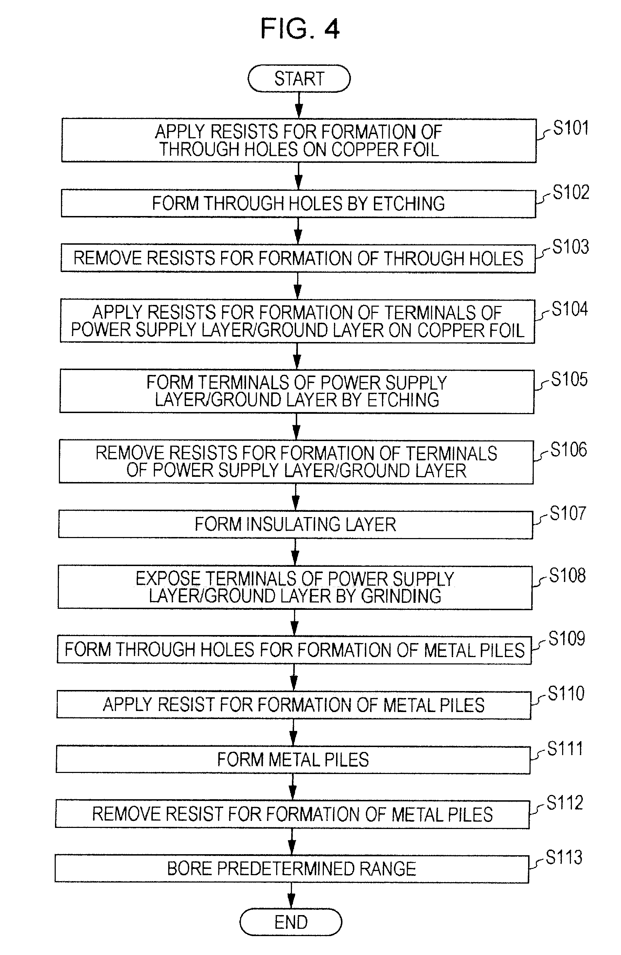

FIG. 4 is a flowchart illustrating a procedure for fabricating the interposer according to the second embodiment. The procedure for fabricating the interposer 20a is carried out manually or by a predetermined fabrication apparatus. As illustrated in FIG. 4, resists for use in formation of through holes are applied on a copper foil serving as a substrate of the interposer 20a and as a power supply layer or a ground layer (S101).

The through holes are then formed in the copper foil by etching using the resists applied on the copper foil in OPEATION S101 (S102). Thereafter, the resists used in the formation of the through holes are removed from the copper foil having the through holes formed in OPERATION S102 (S103).

Resists for use in formation of terminals of a power supply layer or a ground layer are then applied on the copper foil having the through holes formed in OPERATION S102 (S104). The power-supply-layer or ground-layer terminals are formed in the copper foil by etching (S105). The resists are then removed from the copper foil having the power-supply-layer or ground-layer terminals (S106).

Thereafter, an insulating layer is formed using a glass fiber reinforced epoxy resin to wrap the copper foil having the power-supply-layer or ground-layer terminals (S107). Parts of the insulating layer formed to wrap the power-supply-layer or ground-layer terminals of the copper foil in OPERATION S107 is ground so that parts of the power-supply-layer or ground-layer terminals are exposed from the insulating layer (S108).

Through holes for use in formation of metal piles are formed by laser processing at positions of the through holes of the copper foil covered with the insulating layer in OPERATION S107 to have an inside diameter smaller than the through holes of the copper foil (S109). A resist for use in formation of the metal piles is then applied to cover the insulating layer having the through holes formed in OPERATION S109 (S110).

Thereafter, the metal piles are formed by copper plating in the metal-pile formation through holes of the insulating layer to which the resist is applied in OPERATION S110 (S111). The resist used in the formation of the metal piles is removed from the insulating layer having the metal piles (S112). A range of the interposer, which physically interferes with capacitors arranged on the opposite surface of an LSI package to the surface mounting an LSI when the LSI package is mounted on the insulating layer, is bored to form a through hole (S113).

### [Processes for mounting semiconductor package on interposer]

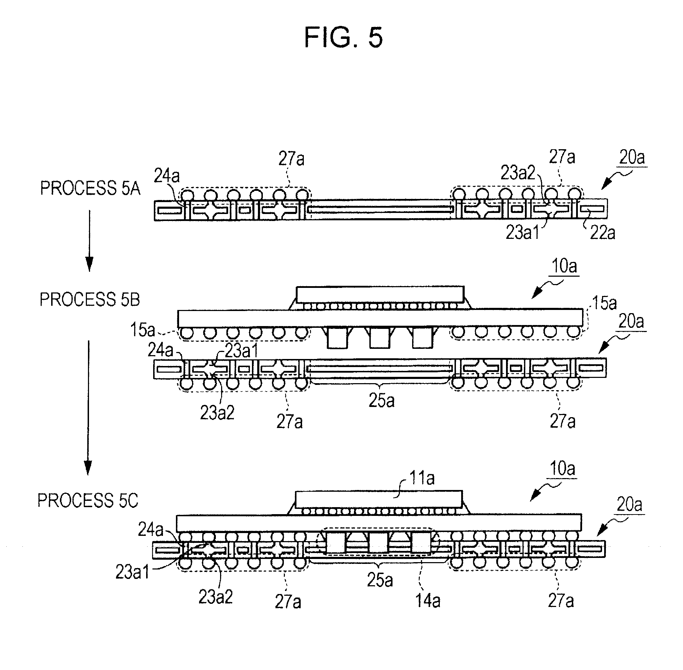

FIG. 5 is a diagram illustrating processes for mounting a semiconductor package on the interposer according to the second embodiment. As illustrated in PROCESS 5A, solder balls 27a are joined to the metal piles 24a and the second connection terminals 23a2 exposed on one surface of the plate-like interposer 20a.

As illustrated in PROCESS 5B, the interposer 20a holding the solder balls 27a joined thereto in PROCESS 5A is turned over. The LSI package 10a having connection terminals joined to solder balls 15a is then mounted on the other surface not holding the solder balls 27a in the interposer 20a.

Thereafter, as illustrated in PROCESS 5C, the connection terminals of the LSI package 10a are connected to the corresponding first connection terminals 23a1 and the exposed parts of the metal piles 24a by, for example, reflow soldering. When the LSI package 10a is mounted on the interposer 20a, capacitors 14a arranged on the opposite surface of the LSI package to the surface mounting the LSI 11aare placed in the through hole 25a.

### [Process for mounting an LSI package on a mother board]

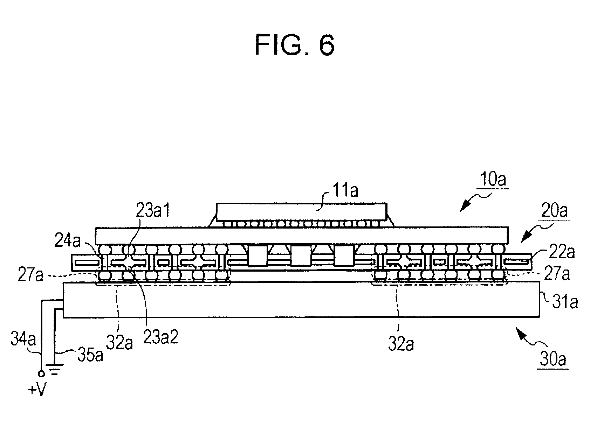

FIG. 6 is a diagram illustrating a process for mounting an LSI package on a mother board using the interposer according to the second embodiment. As illustrated in FIG. 6, the second connection terminals 23a2 and the metal piles 24a of the interposer 20a are connected to connection terminals 32a disposed on a substrate 31a of a mother board 30a with the solder balls 27a.

The mother board 30a includes a power supply line 34a for supplying an electric signal to the LSI package 10a by using at least one of the metal piles 24a as a power supply conductive member. The mother board 30a also includes a ground line 35a for connecting the LSI package 10a to ground through the first connection terminals 23a1, the metal plate 22a, and the second connection terminals 23a2 of the interposer 20a.

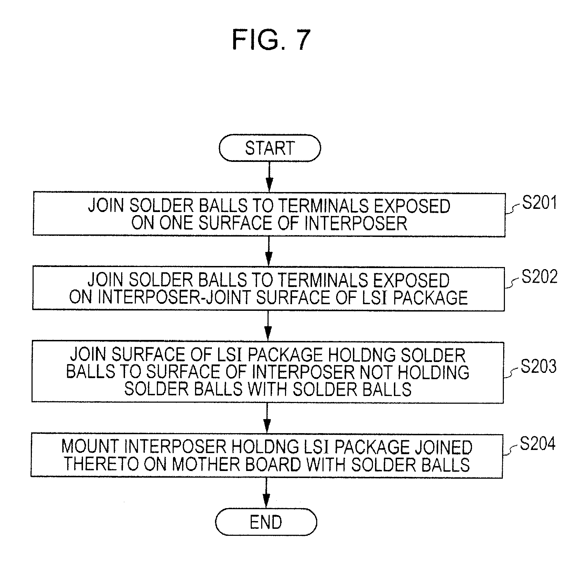

FIG. 7 is a flowchart illustrating a procedure for mounting an LSI package on a mother board using the interposer according to the second embodiment. The procedure for mounting the LSI package on the mother board using the interposer is carried out manually or by a predetermined mounting apparatus.

Solder balls are joined to terminals exposed on one surface of the interposer (S201). Thereafter, solder balls are joined to terminals exposed on a surface of the LSI package to be connected to the interposer (S202).

The surface of the LSI package holding the solder balls is then joined to a surface of the interposer not holding solder balls with the solder balls of the LSI package so that the LSI package is mounted on the interposer (S203). Thereafter, the interposer holding the LSI package joined thereto is mounted on the mother board with the solder balls of the interposer (S204).

As described above, in accordance with the second embodiment, the interposer 20a disposed between the LSI package 10a and the mother board 30a electrically connects the LSI package 10a to the mother board 30a and functions as a stiffener. The second embodiment allows the interposer 20a having functions of an electrical connector and a stiffener, and including a metal plate functioning as a power supply layer or a ground layer to be fabricated in a simple fabrication method and provided at a low cost.

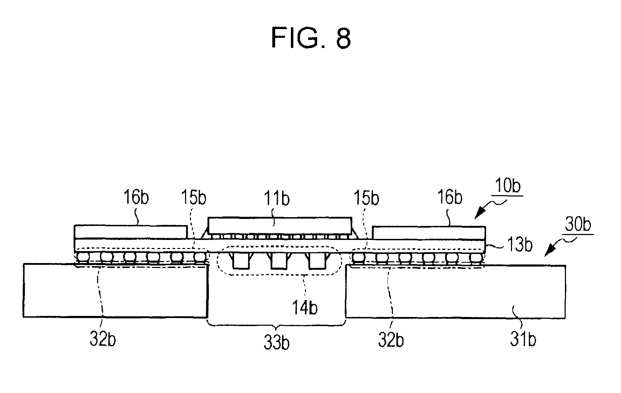

The second embodiment omits a stiffener 16b mounted on a package substrate 13b of an LSI package 10b illustrated in a comparative example for mounting the LSI package 10b on a mother board 30b in FIG. 8. Since the interposer 20a functions as a stiffener, the interposer 20a has a reinforcing effect higher than the comparative example.

Discussion will be given for a case of mounting the LSI package 10b directly on the mother board 30b with solder balls 15b and connection terminals 32b arranged on a substrate 31b of the mother board 30b as illustrated in FIG. 8. In such a case, physical interference between the mother board 30b and capacitors 14b arranged on a surface opposite to a surface mounting an LSI 11b has to be avoided.

The use of the interposer 20a allows interference between the capacitors 14a and the mother board 30a to be avoided without an interference-preventing hole 33b formed by countersinking or boring an interfering range of the mother board 30b. Thus, a wire for supplying electric power to the LSI 11a does not have to be arranged to detour around an interference-preventing part in the mother board 30a, which leads to stable supply of electric power to the LSI 11a.

Each connection terminal of the interposer 20a is connected to the corresponding connection terminal of the LSI package 10a or the mother board 30a by reflow soldering using a solder ball. However, the connection method is not limited to the reflow soldering and may be made with an adhesive or by directly soldering the corresponding connection terminals.

One embodiment of the disclosed technology advantageously allows a semiconductor-element package to be mounted on a circuit board without increasing a fabrication cost of the semiconductor-element package and without decreasing electric performance of the semiconductor-element package and the circuit board.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the scope of the invention.

## Claims

1. An interconnect board for interconnecting and arranged between a first circuit board and a second circuit board, the interconnect board comprising:
a conductive plate including a connection terminal to be electrically connected to a power supply terminal or a ground terminal of each of the first circuit board and the second circuit board;
an insulating member wrapping the conductive plate except for the connection terminal; and
a conductive member penetrating the insulating member to electrically connect a signal terminal of the first circuit board to a signal terminal of the second circuit board.

2. The interconnect board according to claim 1, wherein the interconnect board has a through hole so that an electronic component arranged on the first circuit board is placed in the through hole when the interconnect board is arranged between the first circuit board and the second circuit board.

3. A printed circuit board unit comprising:
a first circuit board;
a second circuit board; and
an interconnect board arranged between a first circuit board and a second circuit board, the interconnect board including:
a conductive plate including a connection terminal to be electrically connected to a power supply terminal or a ground terminal of each of the first circuit board and the second circuit board,
an insulating member wrapping the conductive plate except for the connection terminal, and
a conductive member penetrating the insulating member to electrically connect a signal terminal of the first circuit board to a signal terminal of the second circuit board.

4. The printed circuit board unit according to claim 3, wherein the interconnect board having a through hole so that an electronic component arranged on the first circuit board is placed in the through hole.

5. The printed circuit board unit according to claim 4, wherein the first circuit board is a semiconductor element package mounting a semiconductor element, and the through hole faces an electronic component arranged on an opposite surface of the semiconductor element package to a surface with the semiconductor element.

6. The printed circuit board unit according to claim 3, further comprising:
a power supply conductive member penetrating the insulating member,
wherein the power supply conductive member is connected to the power supply terminal when the connection terminal is connected to the ground terminal.

7. A method for fabricating an interconnect board for interconnecting and arranged between a first circuit board and a second circuit board, the method comprising:
applying a first resist at a first predetermined portion of a conductive plate having a low thermal expansion property to form a first through hole;
forming the first through hole in the conductive plate having the first resist by etching;
removing the first resist from the conductive plate after the formation of the first through hole;
applying a second resist at a second predetermined portion of the conductive plate having the first through hole to form a connection terminal electrically connected to a power supply terminal or a ground terminal of each of the first circuit board and the second circuit board;
forming the connection terminal in the conductive plate by etching; and
removing the second resist from the conductive plate after the formation of the connection terminal;
forming an insulating member to wrap the conductive plate having the connection terminal;
grinding a surface of the insulating member to expose an end of the connection terminal from the surface of the insulating member;
forming a second through hole in the first through hole covered with the insulating member to form a via, the second through hole having an inside diameter smaller than the first through hole;
applying a third resist on the conductive plate having the second through hole to form the via;
forming the via in the second through hole of the conductive plate having the third resist with a conductive material;
removing the third resist from the conductive plate after the formation of the via; and
forming a third through hole at a range facing an electronic component arranged on the first circuit board so that the electronic component is placed in the third through hole when the interconnect board is arranged between the first circuit board and the second circuit board.

8. The method according to claim 7, wherein the first circuit board is a semiconductor element package mounting a semiconductor element, and the third through hole is formed at a range facing an electronic component arranged on an opposite surface of the semiconductor element package to a surface with the semiconductor element.
